# FASCICULE DE BREVET EUROPEEN

(11) **EP 3 221 952 B1**
(45) Date de publication et mention de la délivrance du brevet: **26.12.2018**
(21) Numéro de dépôt: 15798078.0
(22) Date de dépôt: 20.11.2015
(51) Int. Cl.: H02K 11/04

(54) **CONVERTISSEUR ALTERNATIF-CONTINU**
WECHSELSTROM-GLEICHSTROM-WANDLER
AC/DC CONVERTER

(30) Priorité: 20.11.2014 FR 1461267
(43) Date de publication de la demande: 27.09.2017
(73) Titulaire: Valeo Equipements Electriques Moteur, 94046 Créteil Cedex (FR)
(72) Inventeur: GUERIN, Fabien, 94046 Créteil (FR); LUO, Yaowen, 95800 Cergy Saint-Christophe (FR); LI, Ronghui, 95800 Cergy Saint-Christophe (FR); LUCOT, Guillaume, 95800 Cergy Saint-Christophe (FR); MACHRHOUL, Rachid, 95800 Cergy Saint-Christophe (FR); REN, Xiaojun, 95800 Cergy Saint-Christophe (FR)
(74) Mandataire: Cardon, Nicolas
(86) Numéro de dépôt international: PCT/EP2015/077228
(87) Numéro de publication internationale: WO 2016/079301

(56) Documents cités:
- WO-A1-2014/103482
- JP-A- 2014 117 005

## Description

La présente invention concerne un convertisseur alternatif-continu destiné à être intégré dans une machine électrique tournante.

L'électronique de puissance a remplacé de nos jours les moyens électro- mécaniques d'autrefois pour l'alimentation électrique et le contrôle des machines électriques tournantes modernes.

Que ce soit des machines électriques tournantes monophasées ou polyphasées, synchrones ou asynchrones, fonctionnant en moteur ou en générateur, un ou plusieurs modules électroniques de puissance contrôlent les courants et les tensions appliqués.

Un équipement courant d'un véhicule automobile est constitué par une machine électrique tournante réversible, c'est-à-dire qui est apte à fonctionner en génératrice et à charger une batterie quand elle est couplée au moteur thermique du véhicule, et à fonctionner en moteur pour le démarrage, ou la fourniture d'un surcroît de puissance mécanique, quand elle est alimentée par le réseau électrique de bord.

Cette machine, dite "alterno-démarreur" comporte le plus souvent:
- un rotor comprenant des aimants permanents et/ ou un inducteur dans lequel est amené un courant d'excitation;
- un stator comprenant des enroulements de phases dans lesquels circulent des courants de phases.

La demande de brevet FR2886506 de la société VALEO EQUIPEMENTS ELECTRIQUES MOTEUR ou le document WO2014/103482 décrivent de façon extrêmement détaillée la mécatronique d'un alterno-démarreur triphasé comprenant :
- un module d'excitation constituant un porte-balais régulateur contrôlant le courant d'excitation ;
- trois modules de puissance d'un convertisseur alternatif - continu générant les courants de phases en mode moteur ou redressant les courants de phase en mode alternateur;
- un module de commande du module d'excitation et des modules de puissance ;
- un dispositif de refroidissement, généralement composé d'un dissipateur de chaleur incluant un circuit hydraulique de refroidissement.

Les modules de puissance se présentent sous la forme de boîtiers, un par phase, munis extérieurement d'éléments de connexion et sont agencés sur le palier arrière de l'alterno-démarreur. Ces modules sont fixés au dispositif de refroidissement afin de permettre le transfert thermique entre lesdits modules de puissances vers le circuit de refroidissement, dans le but de dissiper la chaleur générée par les modules de puissance.

Pour contrôler ces modules de puissance, une carte de commande est connectée aux éléments extérieurs de connexion des modules. Cette carte de commande, généralement placée au-dessus des modules de puissances pour faciliter la connexion, est donc éloignée du système de refroidissement sur lequel les modules de puissances sont fixés. Cependant, la carte de commande génère une chaleur qu'il est nécessaire de dissiper pour éviter toute détérioration des composants présents sur ladite carte de commande.

Des contraintes de place et de disposition des composants limitent les possibilités de placement de la carte de contrôle vis-à-vis de l'ensemble. Il n'est donc pas possible de placer la carte de contrôle à proximité du dispositif de refroidissement. Il est donc nécessaire d'établir un moyen de refroidir la carte de contrôle, tout en prenant en compte l'espace alloué aux composants sur le convertisseur alternatif-continu.

La présente invention vise à décrire un moyen de fixation destiné à fixer les différents éléments d'un convertisseur alternatif-continu, tout en effectuant une fonction de transfert thermique de la carte de commande vers le dispositif de refroidissement pour palier le problème mentionné précédemment.

À cet effet, la présente invention a pour objet un convertisseur alternatif-continu destiné à être intégré dans une machine électrique tournante, comprenant au moins un module de puissance, un module de contrôle permettant de contrôler le au moins un module de puissance, un dispositif de refroidissement, dans lequel le au moins un module de puissance est fixé au dispositif de refroidissement par l'intermédiaire d'au moins un moyen de fixation, et le module de contrôle repose sur le au moins un moyen de fixation de sorte à transférer la chaleur générée par au moins une partie du module de contrôle vers le dispositif de refroidissement.

Avantageusement, l'utilisation de moyens de fixation pour fixer les modules de puissance au dispositif de refroidissement, et la réalisation d'une liaison thermique entre la carte de contrôle et ledit dispositif de refroidissement par l'intermédiaire d'une surface de contact entre lesdits moyens de fixation et la carte de contrôle, permettent d'efficacement dissiper la chaleur présente sur la carte de contrôle sans recourir à un autre dispositif de refroidissement, réduisant ainsi la taille du dispositif de refroidissement et ainsi de l'ensemble du convertisseur alternatif-continu.

De plus, le dimensionnement des moyens de fixation permettent de ne pas interférer avec les composants présents sur la carte de contrôle.

Le convertisseur alternatif-continu destiné à être intégré à une machine électrique tournante selon l'invention peut également comprendre une ou plusieurs des caractéristiques ci-dessous, considérées individuellement ou selon toutes les combinaisons techniquement possibles :
- Le moyen de fixation est réalisé dans un matériau ayant une résistance mécanique supérieure à 400 MPa et un coefficient de conductivité thermique supérieur à 100 W/mK ; et/ou
- Le module de contrôle repose sur une surface de contact plane du moyen de fixation, ladite surface plane étant sensiblement parallèle au plan moyen du module de contrôle ; et/ou
- La surface de contact du moyen de fixation est supérieure ou égale à celle du ou des composant(s) du module de contrôle à refroidir ; et/ou
- Le convertisseur alternatif-continu selon l'invention comprend entre le moyen de fixation et le module de contrôle une glu thermique ; et/ou
- Le moyen de fixation est réalisé en aluminium 7075-T6 ; et/ou
- Le moyen de fixation est une vis composée d'un filetage et d'une tête de vis, le filetage permettant la fixation du module de puissance avec le dispositif de refroidissement et le module de contrôle reposant sur la tête de vis ; et/ou
- Ladite tête de vis est de forme hexagonale.

L'invention se rapporte également à une machine électrique tournante comprenant un convertisseur alternatif-continu selon l'invention.

L'invention sera mieux comprise à la lumière de la description suivante qui n'est donnée qu'à titre indicatif et qui n'a pas pour but de limiter ladite invention, accompagnée des figures ci-dessous :
- La figure 1 est une vie isométrique du convertisseur alternatif-continu selon l'art antérieur ;
- La figure 2 représente un mode de réalisation d'un convertisseur alternatif-continu selon l'invention ;
- La figure 3a et 3b représente respectivement deux modes de réalisation de moyens de fixation selon l'invention ;
- La figure 4 représente une vue de coupe d'un moyen de fixation selon l'invention en interaction avec les différents éléments du convertisseur alternatif-continu.

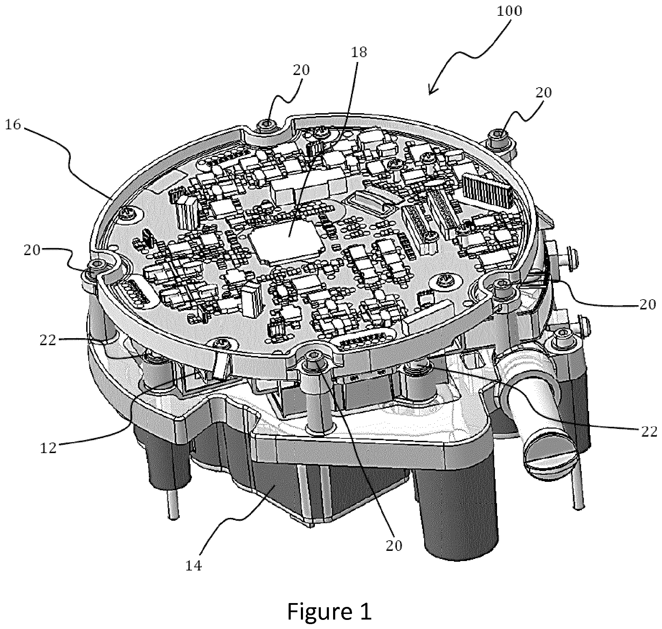

La figure 1 représente un convertisseur alternatif-continu 100 destiné à une machine électrique tournante de véhicule selon l'art antérieur. Le convertisseur alternatif-continu 100 comprend un dispositif de refroidissement 14, des modules de puissance 12 disposés au-dessus dudit dispositif de refroidissement 14 et une carte de contrôle 16. La carte de contrôle 16 est fixée au dispositif de refroidissement 14 par l'intermédiaire des vis 20, disposées sur le pourtour de la carte de contrôle 16. Les modules de puissance 12 sont aussi fixés au dispositif de refroidissement 14 par l'intermédiaire de vis 22 placées de part et d'autre des modules de puissance 12. Un exemple de module de puissance 12 est décrit dans le brevet FR3014257 (publié le 05.06.2015).

La carte de contrôle 16 comprend des composants 18 qui permettent entre autres de commander les modules de puissance 12. Ces composants 18, cependant, génère de la chaleur lors du fonctionnement du convertisseur alternatif-continu 100. Le convertisseur alternatif-continu 100 tel que présenté en figure 1 ne dispose pas de moyen pour refroidir la carte de contrôle 16. Il est cependant nécessaire de dissiper la chaleur présente dans ces composants pour éviter de réduire leur durée de vie ou d'interférer avec leur bon fonctionnement.

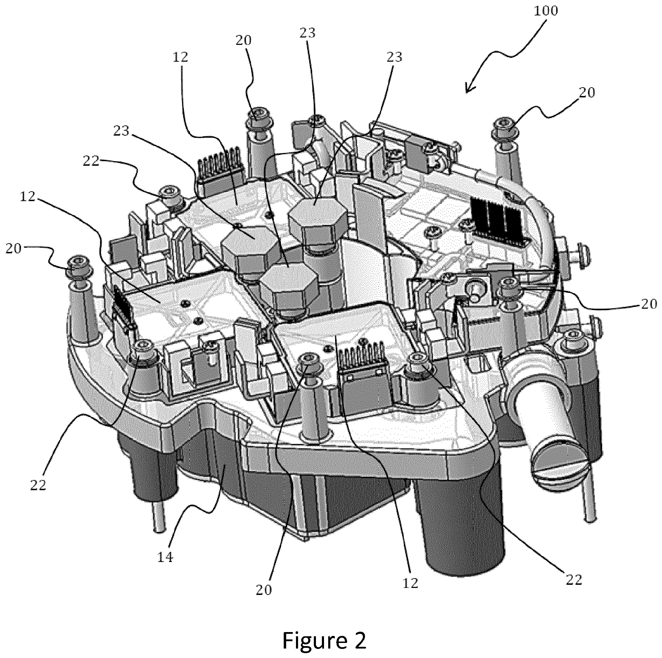

L'invention ci-présente propose de remplacer au moins une partie des vis 22 de fixations des modules de puissance 12 avec le dispositif de refroidissement 14, par des vis spéciales 23 comme présentée en figure 2.

La figure 2 représente un convertisseur alternatif-continu 100 selon un mode de réalisation de l'invention. Le convertisseur alternatif-continu 100 comprend un dispositif de refroidissement 14, des modules de puissance 12 disposés au-dessus dudit dispositif de refroidissement 14 et une carte de contrôle 16 (non représentée sur la figure 2). La carte de contrôle 16 est fixée au dispositif de refroidissement 14 par l'intermédiaire des vis 20, disposées sur le pourtour de la carte de contrôle 16. Les modules de puissance 12 sont aussi fixés au dispositif de refroidissement 14 par l'intermédiaire de vis 22 d'une part et par l'intermédiaire de vis spéciales 23 placées en diagonale des vis 22 sur un même module de puissance 12.

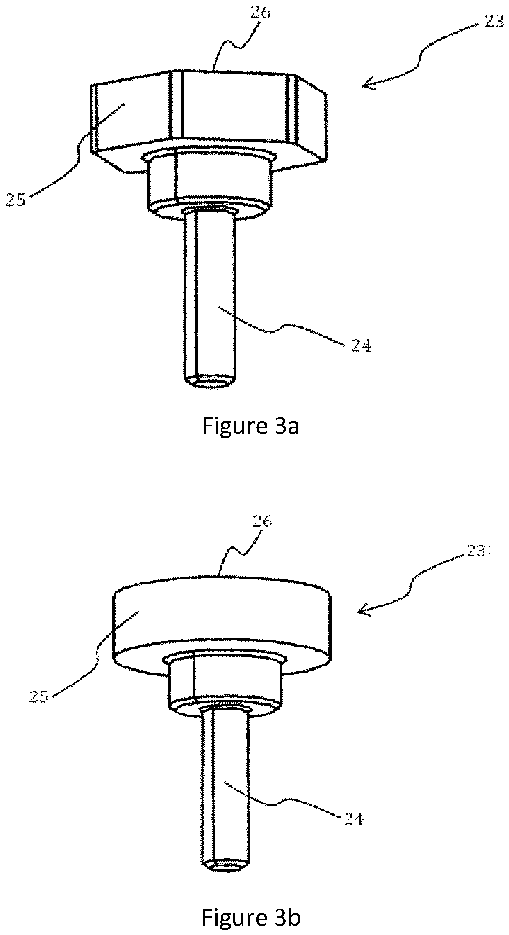

Ces vis spéciales 23 sont composées d'un filetage 24 et d'une tête de vis 25, pouvant être de forme hexagonale comme présentée en figure 3a, ou de forme cylindrique comme présentée en figure 3b.

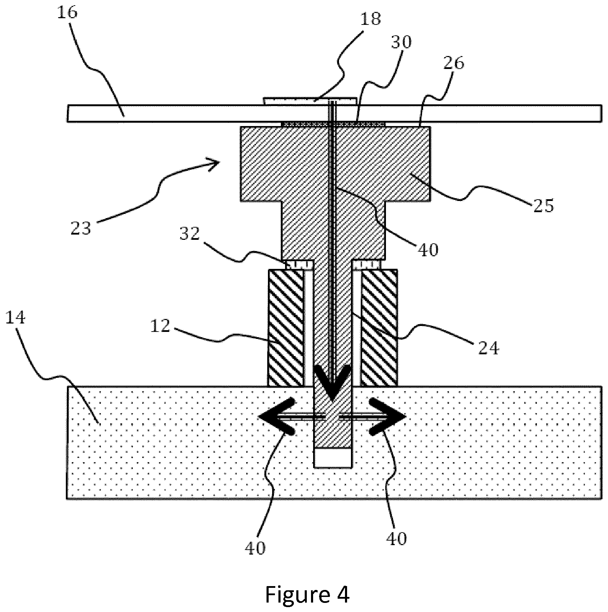

La surface 26 située au-dessus de la tête de vis 25 est de forme plate, de telle sorte qu'une fois les vis spéciales 23 placées et vissées, la surface 26 est sensiblement parallèle au plan moyen de la carte de contrôle 16 placée au-dessus, comme présenté en figure 4. Ainsi, la surface plane 26 de la vis spéciale 23 est en contact avec la surface arrière de la carte de contrôle 16.

La disposition présentée en figure 4, utilisant les vis spéciales 23 pour la fixation des modules de puissance 12 avec le module de refroidissement 14, permet d'effectuer un transfert thermique partant des composants 18 chauffants sur la surface de la carte de contrôle 16 jusqu'au système de refroidissement 14, par l'intermédiaire des vis spéciales 23. La chaleur dissipée des composants 18 suit alors le chemin représentée par les flèches 40 sur la figure 4.

De plus, la surface 26 de la tête de vis 25 de la vis spéciale 23 est généralement supérieure à la surface des composants 18 présent sur la carte de contrôle 16, afin d'assurer que la chaleur dissipée par lesdits composants 18 soit intégralement transférer aux vis spéciales 23 et permettre une diffusion améliorée de la chaleur présente sur la carte de contrôle 16.

L'utilisation de ces vis spéciales 23 permettent donc de réaliser une fonction de refroidissement sur la carte de contrôle 16, sans modifier le design du dispositif de refroidissement 14. De plus, les vis spéciales 23 n'interfèrent pas avec le placement des modules de puissance 12 ou encore avec les composants 18 de la carte de contrôle 16.

Une glu thermique 30 peut être placée entre la surface arrière de la carte de contrôle 16 et la surface 26 de la tête de vis 25, afin de faciliter le transfert thermique entre les deux surface. De plus, l'utilisation d'une glu thermique 30 permet de d'assurer une fixation supplémentaire sur le centre de la carte de contrôle 16 et ainsi limiter les vibrations générées par le fonctionnement du convertisseur alternatif-continu 100 au sein d'une machine électrique tournante.

Lors de la fixation de la vis spéciale 23, le module de puissance 12 est maintenu serré avec le dispositif de refroidissement 14. Une rondelle 32, par exemple en acier, est disposée entre une surface plane de la vis et le module de puissance 12 pour répartir le couple de serrage de la vis afin d'éviter d'endommager le module puissance 12 lors du vissage.

Afin d'assurer la fonction de fixation dans les meilleures conditions, la vis spéciale 23 doit être réalisée dans un matériau avec une résistance mécanique importante, généralement supérieure à 400 MPa. De plus, la vis spéciale 23 servant de diffuseur thermique, il est préférable que le matériau possède un coefficient de conductivité thermique adéquat à sa fonction. Un coefficient de conductivité thermique de l'ordre de 100 W/mK permet de correctement effectuer la fonction de diffusion thermique des composants 18 sur la carte de contrôle 16 jusqu'au dispositif de refroidissement 14.

Parmi l'ensemble des matériaux disponible pouvant être utilisé pour réaliser les vis spéciales 23 selon les modes de réalisation présenté en figure 2, 3a, 3b et 4, l'Aluminium 7075-T6 est particulièrement avantageux en terme de résistance mécanique et de diffusion thermique pour la réalisation des vis spéciales 23.

L'invention a été décrite ci-dessus avec l'aide de modes de réalisation présentés sur des figures, sans limitation du concept inventif général, tel que définit dans les revendications.

## Revendications

1. Convertisseur alternatif - continu (100) destiné à être intégré dans une machine électrique tournante, comprenant :
- au moins un module de puissance (12),
- un module de contrôle (16) permettant de contrôler le au moins un module de puissance,
- un dispositif de refroidissement (14),
dans lequel le au moins un module de puissance est fixé au dispositif de refroidissement par l'intermédiaire d'au moins un moyen de fixation (23), et
le module de contrôle repose sur le au moins un moyen de fixation de sorte à transférer la chaleur générée par au moins une partie du module de contrôle vers le dispositif de refroidissement.

2. Convertisseur alternatif - continu selon la revendication 1, dans lequel le moyen de fixation est réalisé dans un matériau ayant une résistance mécanique supérieure à 400 MPa et un coefficient de conductivité thermique supérieur à 100 W/mK.

3. Convertisseur alternatif - continu selon la revendication 1 ou 2, dans lequel le module de contrôle repose sur une surface de contact plane (26) du moyen de fixation, ladite surface plane étant sensiblement parallèle au plan moyen du module de contrôle.

4. Convertisseur alternatif - continu selon la revendication 3, dans lequel la surface de contact du moyen de fixation est supérieure ou égale à celle d'un ou de composant(s) (18) du module de contrôle à refroidir.

5. Convertisseur alternatif - continu selon l'une des revendications précédentes, comprenant entre le moyen de fixation et le module de contrôle une glu thermique (30).

6. Convertisseur alternatif- continu selon l'une des revendications précédentes, dans lequel le moyen de fixation est réalisé en aluminium 7075-T6.

7. Convertisseur alternatif - continu selon l'une des revendications précédentes, dans lequel le moyen de fixation est une vis composée d'un filetage (24) et d'une tête de vis (25), le filetage permettant la fixation du module de puissance avec le dispositif de refroidissement et le module de contrôle reposant sur la tête de vis.

8. Convertisseur alternatif - continu selon la revendication 7, dans lequel la tête de vis est de forme hexagonale.

9. Machine électrique tournante de véhicule automobile, **caractérisée en ce qu'**elle comprend un convertisseur alternatif -continu (100) selon l'une des revendications précédentes.

## Patentansprüche

1. Wechselstrom-Gleichstrom-Wandler (100), welcher dazu bestimmt ist, in eine rotierende elektrische Maschine integriert zu werden, umfassend:
- wenigstens ein Leistungsmodul (12),
- ein Steuerungsmodul (16), welches ermöglicht, das wenigstens eine Leistungsmodul zu steuern,
- eine Kühlvorrichtung (14),
wobei das wenigstens eine Leistungsmodul an der Kühlvorrichtung durch wenigstens ein Befestigungsmittel (23) befestigt ist, und
das Steuerungsmodul auf dem wenigstens einen Befestigungsmittel ruht, so dass die Wärme, die von wenigstens einem Teil des Steuerungsmoduls erzeugt wird, auf die Kühlvorrichtung übertragen wird.

2. Wechselstrom-Gleichstrom-Wandler nach Anspruch 1, wobei das Befestigungsmittel aus einem Material hergestellt ist, das eine mechanische Festigkeit, die höher als 400 MPa ist, und einen Wärmeleitungskoeffizienten, der höher als 100 W/mK ist, aufweist.

3. Wechselstrom-Gleichstrom-Wandler nach Anspruch 1 oder 2, wobei das Steuerungsmodul auf einer ebenen Kontaktfläche (26) des Befestigungsmittels ruht, wobei diese ebene Fläche im Wesentlichen parallel zur Mittelebene des Steuerungsmoduls ist.

4. Wechselstrom-Gleichstrom-Wandler nach Anspruch 3, wobei die Kontaktfläche des Befestigungsmittels größer oder gleich derjenigen einer Komponente oder von Komponenten (18) des zu kühlenden Steuerungsmoduls ist.

5. Wechselstrom-Gleichstrom-Wandler nach einem der vorhergehenden Ansprüche, welcher zwischen dem Befestigungsmittel und dem Steuerungsmodul einen Wärmeleitkleber (30) umfasst.

6. Wechselstrom-Gleichstrom-Wandler nach einem der vorhergehenden Ansprüche, wobei das Befestigungsmittel aus Aluminium 7075-T6 hergestellt ist.

7. Wechselstrom-Gleichstrom-Wandler nach einem der vorhergehenden Ansprüche, wobei das Befestigungsmittel eine Schraube ist, die aus einem Gewinde (24) und einem Schraubenkopf (25) besteht, wobei das Gewinde die Befestigung des Leistungsmoduls an der Kühlvorrichtung ermöglicht und das Steuerungsmodul auf dem Schraubenkopf ruht.

8. Wechselstrom-Gleichstrom-Wandler nach Anspruch 7, wobei der Schraubenkopf von sechseckiger Form ist.

9. Rotierende elektrische Maschine eines Kraftfahrzeugs, **dadurch gekennzeichnet, dass** sie einen Wechselstrom-Gleichstrom-Wandler (100) nach einem der vorhergehenden Ansprüche umfasst.

## Claims

1. AC/DC converter (100) intended to be incorporated into a rotary electric machine, comprising:
- at least one power module (12),
- a control module (16) making it possible to control the at least one power module,
- a cooling device (14),
in which the at least one power module is fixed to the cooling device by the intermediary of at least one fixing means (23), and
the control module rests on the at least one fixing means in such a way as to transfer the heat generated by at least one part of the control module to the cooling device.

2. AC/DC converter according to Claim 1, wherein the fixing means is made from a material having a mechanical strength greater than 400 MPa and a coefficient of thermal conductivity greater than 100 W/mK.

3. AC/DC converter according to Claim 1 or 2, wherein the control module rests on a flat contact surface (26) of the fixing means, said flat surface being substantially parallel with the median plane of the control module.

4. AC/DC converter according to Claim 3, wherein the contact surface area of the fixing means is greater than or equal to that of the component or components (18) of the control module to be cooled.

5. AC/DC converter according to one of the preceding claims, comprising a thermal adhesive (30) between the fixing means and the control module.

6. AC/DC converter according to one of the preceding claims, wherein the fixing means is made of 7075-T6 aluminum.

7. AC/DC converter according to one of the preceding claims, wherein the fixing means is a screw composed of a thread (24) and a screw head (25), the thread allowing the fixing of the power module onto the cooling device and the control module resting on the screw head.

8. AC/DC converter according to Claim 7, wherein said screw head is of hexagonal shape.

9. Rotary electric machine, **characterized in that** it comprises an AC/DC converter (100) according to one of the preceding claims.
